Europäisches Patentamt

(19) European Patent Office

Office européen des brevets

(11) Publication number: **0 076 143**
**B1**

(12) **EUROPEAN PATENT SPECIFICATION**

(45) Date of publication of patent specification: 08.06.88

(51) Int. Cl.⁴: **H 01 L 31/10**

(21) Application number: 82305104.0

(22) Date of filing: 28.09.82

(54) Avalanche photodiode.

(30) Priority: 30.09.81 JP 154984/81

(43) Date of publication of application:
06.04.83 Bulletin 83/14

(45) Publication of the grant of the patent:
08.06.88 Bulletin 88/23

(84) Designated Contracting States:
DE FR GB SE

(56) References cited:
FR-A-2 331 884

APPLIED PHYSICS LETTERS, vol. 34, no. 12,
June 1979, pages 866-868, New York, USA
T.KANEDA et al.: "Shallow-junction p+-n
germaniumavalanche photodiodes (ADP's)
PATENTS ABSTRACTS OF JAPAN, vol. 5, no.
117(E-67)(789), 28th July 1981

(73) Proprietor: FUJITSU LIMITED
1015, Kamikodanaka Nakahara-ku
Kawasaki-shi Kanagawa 211 (JP)

(72) Inventor: Mikawa, Takashi
1-29-106 Fujimidai
Kunitachi-shi Tokyo 186 (JP)
Inventor: Kagawa, Shuzo
1-16-401 Nijigaoka 3-chome Asao-ku
Kawasaki-shi Kanagawa 215 (JP)
Inventor: Honma, Katsuji
2-2-46-1016 Morino
Machida-shi Tokyo 194 (JP)
Inventor: Kaneda, Takao
1380 Kamikodanaka Nakahara-ku
Kawasaki-shi Kanagawa 211 (JP)

(74) Representative: Rackham, Stephen Neil et al
GILL JENNINGS & EVERY 53-64 Chancery Lane
London WC2A 1HN (GB)

Courier Press, Leamington Spa, England.

## Description

This invention relates to an avalanche photodiode (APD), more particularly a germanium avalanche photodiode (Ge APD) for use in 1.5 µm band optical communication.

Recently, an optical fibre having an extremely low transmission loss of 0.2 dB/km with 1.5 µm band wavelength light was developed, and, 1.5 µm band optical communication therefore, began to attract attention from all directions, which requires the development of photodiodes for the 1.5 µm band light. Vigorous efforts aiming at photodiodes for 1.5 µm band light have been made to investigate indium gallium arsenide InGaAs system APDs, but they have problems in view of their crystalline characteristics and processes, and a practical photodiode of planar type having good guard ring effect has not been obtained. Though Ge APDs are actually used as practical photodiodes for 1.3 µm band light, and these have stable crystalline characteristics and processes, but, up until now a Ge APD has not been devised for 1.5 µm band light.

A prior art step junction type $P^+N$ Ge APD developed for a 1.5 µm band light has a narrow width depletion layer of 2 to 3 µm but the light absorption length of germanium for 1.5 µm band light is as long as 10 to 20 µm due to the lower absorption coefficient of germanium for the 1.5 µm band light. Therefore, a large part of the 1.5 µm band light entering the step junction type $P^+N$ Ge APD is absorbed in the outside region of the depletion layer, resulting in a low speed diffusion current which deteriorates the frequency characteristics and the pulse response characteristic of the photodiode. To widen the width of the depletion layer of a junction type $P^+N$ Ge APD to 10 to 20 µm, the concentration of N type impurity (donor) in germanium must be reduced to below about $1 \times 10^{15}$ cm$^{-3}$. However, if the concentration of N type impurity in germanium of a junction type $P^+N$ Ge APD is reduced to below about $1 \times 10^{15}$ cm$^{-3}$, the breakdown voltage at a photo-receiving portion of the APD rises to above 150 V, as high as that at a guard ring portion formed in the APD, which makes it difficult to obtain junction type $P^+N$ Ge APD having a good guard ring effect.

A photodiode comprising a semiconductor substrate comprising an $N^-$ type region; a $P^+$ type region in the substrate and adjacent the surface of the substrate; and an N type region in the substrate interposed between the $P^+$ type region and the $N^-$ type region, is shown in FR—A—2331884. This specification describes a method of making a semiconductor device by the implantation of ions through a bevelled oxide layer so using only a single masking step. The specification specifically describes the production of a capacitance diode on a silicon substrate but postulates that a similar method could also be used with germanium or gallium arsenide substrates and in the production of other semiconductor devices such as avalanche and zener diodes and devices not including pn junctions.

According to this invention in such a photodiode the substrate consists of germanium having an $N^-$ type impurity concentration below $1 \times 10^{15}$ cm$^{-3}$, the thickness of the N type region is comprised between 1.5 and 2.5 µm, the concentration of the impurity in the N type region at the side adjacent the $P^+$ type region is comprised between $1 \times 10^{16}$ cm$^{-3}$ and $1 \times 10^{17}$ cm$^{-3}$, a P type region surrounds the N type region and the $P^+$ type region, the later extending partially into the P type region, and extends down into the substrate to form a guard ring, the breakdown voltage of the pn junction formed between the $P^+$ type region and the N type region or the $N^-$ type substrate is less than that of the pn junction formed between the P type region forming the guard ring and the $N^-$ type substrate.

It is preferred that the region is formed by implanting an N type impurity with a concentration distribution in a direction from its one side adjacent the $P^+$ type region (2) towards its other side adjacent the $N^-$ type region which is approximately Guassian in form.

A particular example of a reach through avalanche photodiode in accordance with the invention will be described with reference to the accompanying drawings; in which:—

Figure 1 is a cross section through a $P^+NN^-$ Ge RAPD;

Figure 2 is a graph of breakdown voltage against arsenic dosage of a $P^+NN^-$ Ge RAPD;

Figures 3a to 3j are cross sections illustrating the process for fabricating a Ge RAPD; and,

Figure 4 is a graph showing pulse response profiles of a Ge RAPD in accordance with this invention and a conventional $P^+N$ Ge APD.

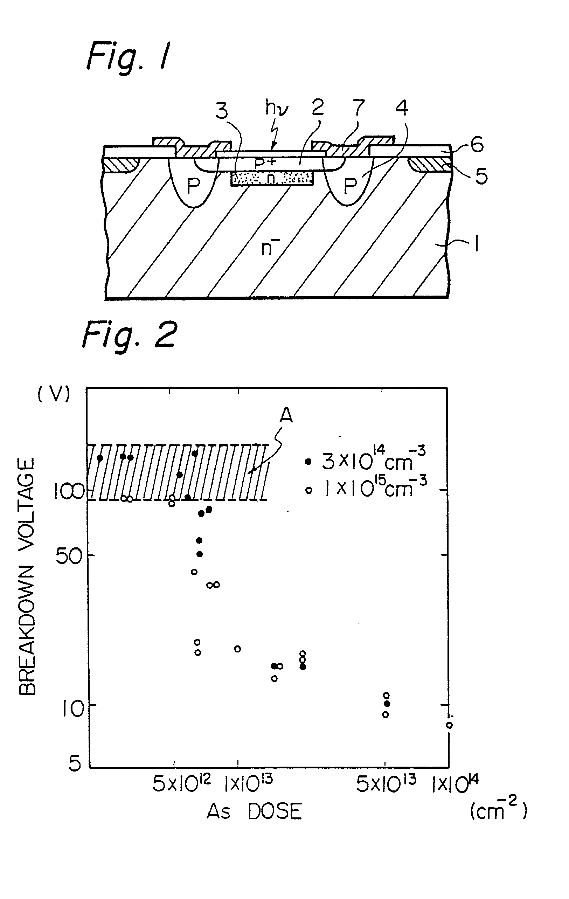

Figure 1 shows an example of Ge RAPD according to the present invention, wherein a germanium (Ge) semiconductor body or substrate comprising an $N^-$ type region 1 contains a $P^+$ type region 2 adjacent to the surface of the substrate 1 as a photo-receiving portion, a P type region 4 enclosing the $P^+$ type region 2 as a guard-ring portion, and an N type region 5 outside the guard-ring portion 4 as a channel stop, and further contains an N type region 3 lying between the $P^+$ type region 2 and $N^-$ type region 1 as a multiplication region. The surface of the substrate 1 is coated with a passivating and nonreflecting film 6, such as a silicon dioxide ($SiO_2$) film, and has an electrode 7. The other electrode not shown in the figure is formed at the opposite side of the substrate 1. Alternatively, thus formed Ge RAPD may be fixed, without said other electrode, on a metal substrate (not shown) by depositing a gold layer on the metal substrate and then heating them so as to form germanium-gold alloy between them.

To determine a preferable concentration of the impurity in the N type region 3 as a multiplicating region, the following experiments were carried out. The Ge RAPDs used in the experiment were similar to the one shown in Fig. 1. The two kinds of germanium substrates 1 used had the concentration of N type impurity (donor), i.e. antimony (Sb), of about $3 \times 10^{14}$ cm$^{-3}$ and about $1 \times 10^{15}$ cm$^{-3}$. The $P^+$ type region 2 as the photo-receiving portion, the P type region 4 as the guard-ring portion, and the N type region 5 as the channel stop, were formed by ion-implantations of indium (In) at an implanting energy of 90 keV and with a dosage of $2\times10^{13}$ cm$^{-2}$, beryllium (Be) at 100 keV and with $1\times10^{14}$ cm$^{-2}$, and arsenic (As) at 130 keV and with $1\times10^{14}$ cm$^{-2}$, respectively. The P$^+$ type region 2 was heat-treated so as to have a junction depth of 0.1 to 0.2 µm. The N type region 3 as the multiplicating region was formed by ion-implantations of As, with the dosage of As being varied, followed by heat treatment so as to form a junction at a depth of 1.5 to 2.5 µm. Breakdown voltages of the thus fabricated Ge RAPDs were measured and shown as a graph of breakdown voltage vs. arsenic dosage in Fig. 2 wherein the marks ● and ○ represent the impurity concentrations in the N$^-$ type region 1 of $3\times10^{14}$ cm$^{-3}$ and $1\times10^{15}$ cm$^{-3}$, respectively, and the area A represents the breakdown voltage at the guard-ring 4.

Where the dosage of arsenic exceeds $1\times10^{13}$ cm$^{-2}$, the breakdown occurs in the N type region 3, and the depletion layer does not extend into the N$^-$ type region 1, thereby a skirt-tailing occurs in the output pulse profile from APD if it receives a 1.5 µm band light in the form of a pulse. Where the dosage of arsenic is below $5\times10^{12}$ cm$^{-2}$, the breakdown voltage at the photo-receiving portion of the APD exceeds 100 V, as high as that at the guard-ring portion, thereby making it impossible to establish an excellent guard-ring action, and, hence, impossible to obtain a multiplication in the photo-receiving portion in the APD. Thus, it is summarized that, in order to fabricate a P$^+$NN$^-$ Ge RAPD exhibiting excellent operating characteristics for a 1.5 µm band light, the dosage of arsenic is preferable to be selected from the range of from $5\times10^{12}$ cm$^{-2}$ to $1\times10^{13}$ cm$^{-2}$.

This preferable dosage of N type impurity in the N type region 3 may apply not only to the case of arsenic ion-implantation but also to the case of a phosphorus (P) ion-implantation, which was suggested by an additional experiment for phosphorus ion-implantation similar to that for arsenic ion-implantation. Further, the N type region 3 may be formed by a diffusion technique. The preferable concentration of N type impurity in the N type region 3 common to the cases of ion-implantation and diffusion techniques may be presented by an aprproximate Gaussian distribution which is about 1.5 µm to 2.5 µm in width and in which the concentration at the side adjacent to the P$^+$ type region is at maximum from about $1\times10^{16}$ cm$^{-3}$ to $1\times10^{17}$ cm$^{-3}$. When the P$^+$ type region 2 has a shallow depth from the surface of the Ge substrate 1, such as about 0.1 to 0.2 µm, the boundary between the N type region 3 and the P$^+$ type region 2 may be considered as if it were positioned at the surface of the Ge substrate 1 in the above-defined distribution of the N type impurity in the N type region 3. This consideration is beneficial when the processing condition necessary for the required doping should be determined.

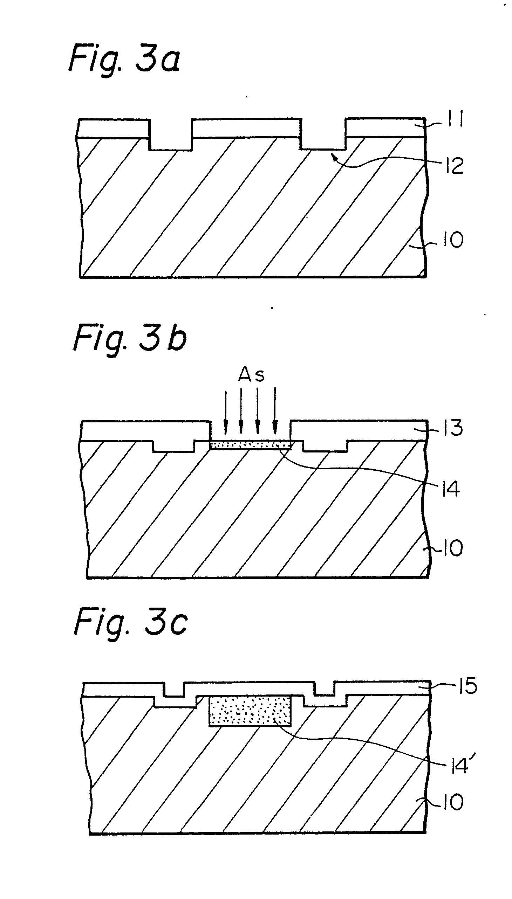

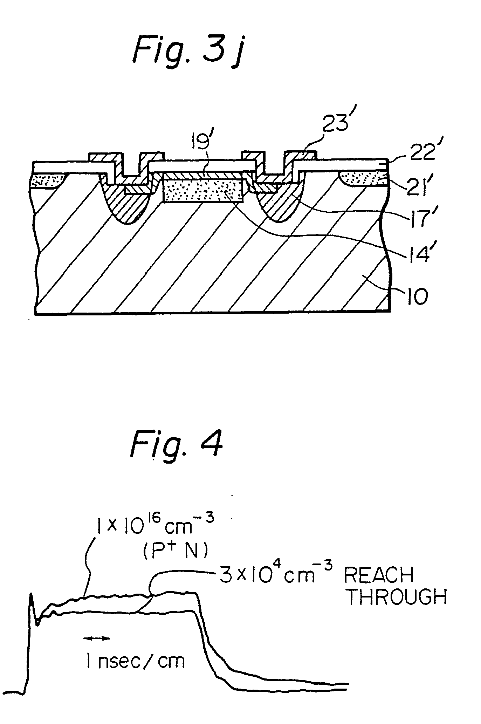

Next, a Ge RAPD was fabricated with a $7\times10^{12}$ cm$^{-2}$ arsenic dosage to evaluate the characteristics of the product. The process for fabricating the Ge RAPD is described below with reference to Figs. 3a through 3j.

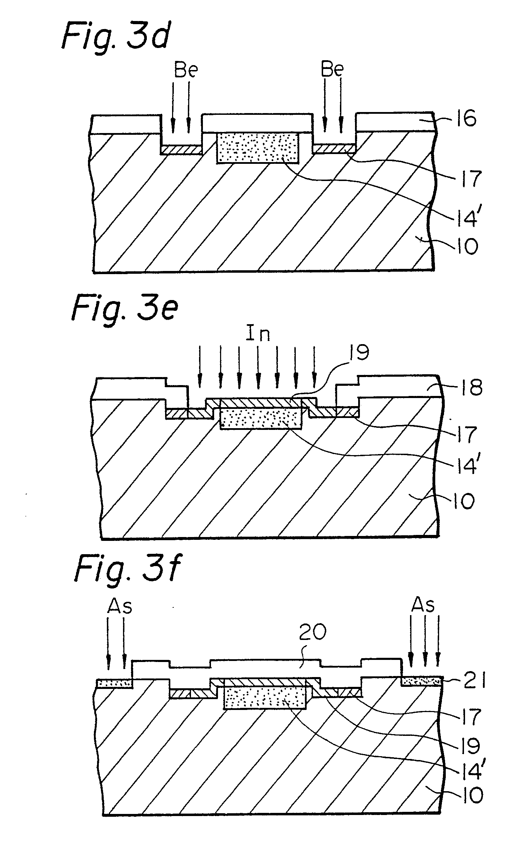

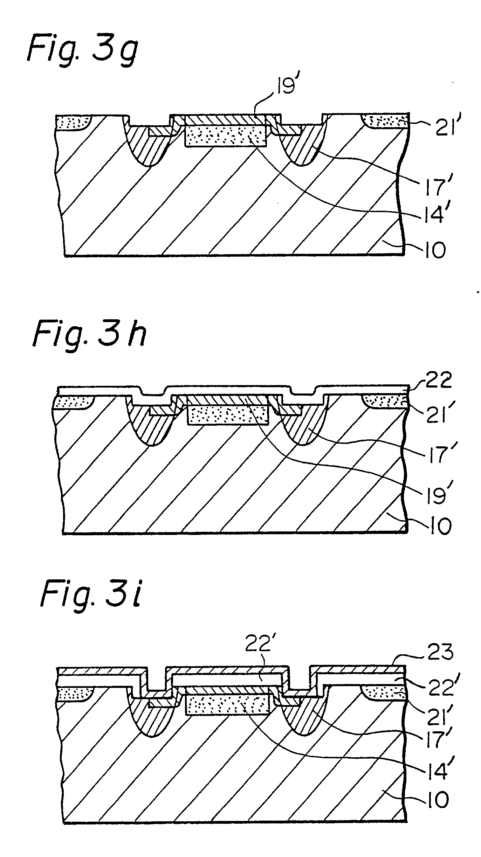

A Ge substrate 10 containing an N type impurity, antimony, in the concentration of about $3\times10^{14}$ cm$^{-3}$ was used. The Ge substrate 10 was coated with a photoresist 11 which was patterned by a photolithographic technique so as to form a marker 12 by etching (Fig. 3a). The marker 12 was an annular groove having an inner and outer diameter of 100 µm and 150 µm, respectively, and a depth of about 200 nm (2000 Å). After removing the photoresist layer 11, the Ge substrate 10 was coated with a new photoresist layer 13 and the photoresist layer 13 was patterned creating a circular opening of 80 µm in diameter so as to effect an ion-implantation of arsenic using the photoresist as a mask (Fig. 3b). This ion-implantation of arsenic was effected at an implanting energy of 130 keV and with a dosage of $7\times10^{12}$ cm$^{-2}$. After the photoresist film 13 was removed, the Ge substrate 10 was covered with a silicon nitride (Si$_3$N$_4$) film 15 and heat treated resulting in an arsenic doped region 14' of about 1.5 to 2.5 µm depth (Fig. 3c). This arsenic doped region 14' is the above-mentioned N type region 3 in the Ge RAPD. After removing the silicon nitride film 15, three ion-implantations of beryllium, indium, and arsenic, were effected (Figs. 3d to 3f). The beryllium was implanted into an annular area 17, the same area as the groove of the marker 12, to form a guard-ring 4 (Fig. 3d). The indium was implanted into a circular area 19, concentric to the marker 12 and having about a 125 µm diameter, to form a P$^+$ type region 2 (Fig. 3e). The arsenic was implanted into an annular area 21, concentric to the marker 12 and having a 210 µm inner diameter, to form a channel stop 5 (Fig. 3f). In these ion-implantations, three patterned photoresists 16, 18 and 20 were used. After the beryllium, indium and arsenic were implanted, the Ge substrate 10 was heat treated at a temperature of 600°C for one hour to form a guard-ring 17' in a 6 to 7 µm depth, a P$^+$ type region 19' in a 0.1 to 0.2 µm depth, and a channel stop 21' in a 0.5 µm depth (Fig. 3g). The Ge substrate 10 was then coated with a silicon dioxide (SiO$_2$) film 22 having a 100 nm to 200 nm (1000 Å to 2000 Å) thickess for passivation and nonreflection (Fig. 3h). In the silicon dioxide film 22 an annular hole over the marker 12 to form an electrode was opened, and over the silicon dioxide film 22' including in the hole, aluminium layer 23 was deposited in a 500 nm to 1000 nm (5000 Å to 10000 Å) thickness and patterned with a photoresist to form an annular electrode 23' having an inner and outer diameter of 80 µm and 150 µm, respectively (Figs. 3i and 3j). Then, the Ge substrate or wafer 10 was scribed into chips. Each of the chips was mounted on metal substrate and wire-bonded. Then, the Ge RAPD was accomplished.

The operating characteristics of the above-fabricated Ge RAPD were evaluated and are shown in the following table:

# 0 076 143

| | |
|---|---|
| Breakdown voltage | about 60 V |
| Reach-through voltage | about 20 V |
| Maximum multiplication factor (when the original photo current at M=1 is about 2 μA) | 60 |
| Capacitance | 0.6 pF at $V_B$ |
| Total dark current | 1 μA at 0.9 $V_B$ |
| Multiplicated dark current | 70 μA at V=1$_V$ |
| Quantum efficiency | 80% |
| Excess noise factor | 6 at M=10 |
| Cutoff frequency | $\leqq$500 MHz |
| Minimum receiving level | −44 dBm at 100 Mb/s error rate of $10^{-11}$ |

M: multiplication factor

$V_B$: breakdown voltage.

Figure 4 shows pulse response profiles of the Ge RAPD as well as the P⁺N type APD in the prior art, which were the responses to a pulse of a 1.53 μm wavelength at M=10. In the figure, the response pulse profile of P⁺N Ge APD has a gentle upward tendency and has a long fall time (from 10% to 90%) of 3.8 ns, indicating a high contribution from the diffusion current. On the other hand, the profile of the Ge RAPD was flat after rising and had a fall time as short as 1.3 ns, and skirt-tailing in the pulse response characteristics of Ge RAPD are greatly improved compared to that of the P⁺N Ge APD.

From the above table and Fig. 4, it can be seen that the Ge RAPD according to the present invention can practically be used in 1.5 μm band optical communication in which the transmission loss is minimised.

## Claims

1. A reach through avalanche photodiode comprising an N⁻ type semiconductor substrate (1); a P⁺ type region (2) in the substrate and adjacent the surface of the substrate; and an N type region (3) interposed between the P⁺ type region (2) and the N⁻ type substrate (1), characterised in that the substrate (1) consists of germanium having an N type impurity concentration below $1 \times 10^{15}$ cm⁻³, in that the thickness of the N type region (3) is comprised between 1.5 and 2.5 μm, in that the concentration of the impurity in the N type region (3) at the side adjacent the P⁺ type region (2) is comprised between $1 \times 10^{16}$ cm⁻³ and $1 \times 10^{17}$ cm⁻³, in that a P type region (4) surrounds the N type region (3) and the P⁺ type region (2), the later extending partially into the P type region (4), and extends down into the substrate (1) to form a guard ring, and in that the breakdown voltage of the pn junction formed between the P⁺ type region (2) and the N type region (3) or the N⁻ type substrate (1) is less than that of the pn junction formed between the P type region (4) forming the guard ring and the N⁻ type substrate (1).

2. A reach through avalanche photodiode according to claim 1, wherein the N type region (3) is doped with arsenic or phosphorus.

3. A reach through avalanche photodiode according to claim 1 or 2 in which the photodiode includes an annular electrode (7) contacting the P type guard ring (4) and admitting light to pass through its centre to the P⁺ type doped region (2) and the N⁻ type substrate (1).

4. A reach through avalanche photodiode according to any one of the preceding claims, wherein the N type region (3) is formed by implanting an N type impurity with a concentration distribution in a direction from its one side adjacent the P⁺ type region (2) towards its other side adjacent the N⁻ type region which is approximately Gaussian in form.

5. A reach through avalanche photodiode according to any one of the preceding claims, wherein the N type region is formed by implanting arsenic ions into the germanium semiconductor substrate (1) in a dose in the range of from $5 \times 10^{12}$ cm⁻² to $1 \times 10^{13}$ cm⁻².

## Patentansprüche

1. Durchgreif-Lawinenphotodiode, mit einem N⁻-Typ-Halbleitersubstrat (1); einem P⁺-Typ-bereich (2) in dem Substrat und angrenzend an der Oberfläche des Substrats; und einem N-Typ-Bereich (3), der zwischen dem P⁺-Typ-Bereich (2) und dem N⁻-Typ-Substrat (1) angeordnet ist, dadurch gekennzeichnet, daß das Substrat (1) aus Germanium besteht und eine Verunreinigungskonzentration vom N-Typ unterhalb $1 \times 10^{15}$ cm⁻³ hat, daß die Dicke des N-Typ-Bereichs (3) 1,5 bis 2,5 μm beträgt, daß die Konzentration der Verunreinigung in dem N-Typ-Bereich (3) an der Seite neben dem P⁺-Typ-Bereich (2) zwischen $1 \times 10^{16}$ cm⁻³ und $1 \times 10^{17}$ cm⁻³ beträgt, daß ein P-Typ-Bereich (4) den N-Typ-Bereich (3) und den P⁺-Typ-Bereich (2) umgibt, letzterer sich teilweise in den P-Typ-Bereich (4) erstreckt und sich nach unten in das Substrat (1) erstreckt, um einen Schutzring zu bilden, und daß die Durchbruchsspannung des pn-Übergangs, der zwischen dem P⁺-Typ-Bereich (2) und dem N-Typ-Bereich (3) oder dem N⁻-Typ-Substrat (1) gebildet ist, kleiner als diejenige des pn-Übergangs ist, der zwischen dem P-Typ-Bereich (4), der den Schutzring bildet und dem N⁻-Typ-Substrat (1) gebildet ist.

4

2. Durchgreif-Lawinenphotodiode nach Anspruch 1, bei der der N-Typ-Bereich (3) mit Arsen oder Phosphor dotiert ist.

3. Durchgreif-Lawinenphotodiode nach Anspruch 1 oder 2, bei der die Photodiode eine Ringelektrode (7) umfaßt, die den P-Typ-Schutzring (4) kontaktiert und Licht durch sein Zentrum zu dem dotierten $P^+$-Typ-Bereich (2) und dem $N^-$-Typ-Substrat (1) hindurchtreten läßt.

4. Durchgreif-Lawinenphotodiode nach einem der vorhergehenden Ansprüche, bei der der N-Typ-Bereich (3) durch Implantieren von N-Typ-Verunreinigungen mit einer Konzentrationsverteilung, welche etwa in Gauss'scher Form ist, in einer Richtung von seiner einen Seite neben dem $P^+$-Typ-Bereich zu seiner anderen Seite neben dem $N^-$-Typ-Bereich (2), gebildet wird.

5. Durchgreif-Lawinenphotodiode nach einem der vorhergehenden Ansprüche, bei der der N-Typ-Bereich durch Implantieren von Arsenionen in das Germaniumhalbleitersubstrat 1 in einer Dosis im Bereich von $5 \times 10^{12}$ cm$^{-2}$ bis $1 \times 10^{13}$ cm$^{-2}$ gebildet wird.

## Revendications

1. A photodiode à avalanche, à traversée, comportant un substrat semi-conducteur (1) de type $N^-$; une région (2) de type $P^+$ dans le substrat et voisine de la surface du substrat; et une région (3) de type N interposée entre la région (2) de type $P^+$ et le substrat (1) de type $N^-$, caractérisée en ce que le substrat (1) est en germanium, ayant une concentration d'impureté de type N inférieure à $1 \times 10^{15}$ cm$^{-3}$, en ce que l'épaisseur dè la région (3) de type N est comprise entre 1,5 et 2,5 micromètres, en ce que la concentration de l'impureté de la région (3) de type N sur le côté voisin de la région (2) de type $P^+$ est comprise entre $1 \times 10^{16}$ cm$^{-3}$ et $1 \times 10^{17}$ cm$^{-3}$, en ce qu'une région (4) de type P entoure la région (3) de type N et la région (2) de type $P^+$, cette dernière s'étendant partiellement dans la région (4) de type P et descendant dans le substrat (1) pour former un anneau de garde et en ce que la tension d'amorçage de la jonction PN formée entre la région (2) de type $P^+$ et la région (3) de type N ou le substrat (1) de type $N^-$ est inférieure à celle de la jonction PN formée entre la région (4) de type P constituant l'anneau de garde et le substrat (1) de type $N^-$.

2. Photodiode à avalanche, à traversée, selon la revendication 1 dans laquelle la région (3) de type N est dopée d'arsenic ou de phosphore.

3. Photodiode à avalanche, à traversée, selon la revendication 1 ou 2 dans laquelle la photodiode comporte une électrode annulaire (7) en contact avec l'anneau de garde (4) de type P et admettant le passage de la lumière par son centre vers la région (2) dopée de type $P^+$ et le substrat (1) de type $N^-$.

4. Photodiode à avalanche, à traversée, selon l'une quelconque des revendications précédentes, dans laquelle la région (3) de type N est formée par implantation d'une impureté de type N avec une distribution de concentration dans une direction partant de son côté voisin de la région (2) de type $P^+$ vers son autre côté voisin de la région de type $N^-$ qui est à peu près de forme gaussienne.

5. Photodiode à avalanche, à traversée, selon l'une quelconque des revendications précédentes dans laquelle la région de type N est formée par implantation d'ions d'arsenic dans le substrat semi-conducteur (1) de germanium avec une dose dans la plage de $5 \times 10^{12}$ cm$^{-2}$ à $1 \times 10^{13}$ cm$^{-2}$.

*Fig. 1*

*Fig. 2*

## Fig. 3a

11

12

10

## Fig. 3b

As

13

14

10

## Fig. 3c

15

14'

10

## Fig. 3d

## Fig. 3e

## Fig. 3f

*Fig. 3g*

*Fig. 3h*

*Fig. 3i*

4

# Fig. 3 j

# Fig. 4

$1 \times 10^{16} cm^{-3}$
$(P^+ N)$

$3 \times 10^4 cm^{-3}$ REACH THROUGH

1 nsec / cm